# EUROPÄISCHE PATENTSCHRIFT

(11) **EP 2 618 381 B1**
(45) Veröffentlichungstag und Bekanntmachung des Hinweises auf die Patenterteilung: **19.03.2014**
(21) Anmeldenummer: 12151581.1
(22) Anmeldetag: 18.01.2012
(51) Int. Cl.: H01L 31/02

(54) **Verbundsystem für Photovoltaik-Anwendung mit Metallfolienrückseite**
Compound system for photovoltaic assembly with metal film reverse
Système composite pour application photovoltaïque dotée d'un partie arrière en feuilles métalliques

(43) Veröffentlichungstag der Anmeldung: 24.07.2013
(73) Patentinhaber: Eppstein Technologies GmbH, 65817 Eppstein (DE)
(72) Erfinder: Waegli, Dr. Peter, 5620 Bremgarten (CH)
(74) Vertreter: Meyer-Dulheuer, Karl-Hermann

(56) Entgegenhaltungen:
- WO-A2-2010/099080
- JP-A- 2011 181 558
- US-A- 6 133 521
- US-A1- 2008 185 033
- US-A1- 2010 051 085
- US-A1- 2010 175 743

## Beschreibung

Die vorliegende Erfindung betrifft ein Verbundsystem für Photovoltaik (PV)-Anwendung mit Metallfolienrückseite, umfassend eine Metallfolie, und eine Isolationsschicht, welche auf die Metallfolie aufgebracht ist, wobei die Metallfolie als Rückwand des PV-Moduls dient und Kontaktinseln enthält, welche sowohl den Kontakt zur PV-Zellenverschaltung als auch die elektrische Verbindung des Moduls zum Bereich außerhalb des Moduls herstellen.

Zudem betrifft die vorliegende Erfindung ein Verfahren zur Herstellung eines entsprechenden Verbundsystems für Photovoltaik-Anwendung.

Ein PV-Modul wandelt Sonnenlicht direkt in elektrische Energie um und enthält als wichtigsten Bestandteil mehrere PV-Zellen (bis zu 60 Zellen), die miteinander verschaltet sind. Die Zellen werden hierfür mittels unterschiedlicher Materialien verpackt und zu einem Verbund zusammengefasst, der mehrere Zwecke erfüllt: Der Verbund bildet eine transparente, strahlungs- und witterungsbeständige Abdeckung und liefert durch die entsprechende Verpackung robuste elektrische Anschlüsse. Die spröden PV-Zellen und elektrischen Verbindungen werden sowohl vor mechanischen Einflüssen als auch vor Feuchtigkeit geschützt. Die elektrischen Bauteile werden vor Zugriffen geschützt und die Module können besser gehandhabt und befestigt werden. Es gibt verschiedenste Bauformen von PV-Modulen mit unterschiedlichen Arten von PV-Zellen.

In der Regel besitzen PV-Module eine Glasplatte auf der zur Sonne gewandten Seite (Frontseite), wobei meist ein sogenanntes Einscheiben-Sicherheits-Glas (ESG) verwendet wird. Über eine transparente Kunststoffschicht, wie beispielsweise Ethylenvinylacetat (EVA) oder Silikongummi, ist diese in der Regel mit den Zellen verbunden. In diese Kunststoffschicht sind die PV-Zellen eingebettet, die durch Lötbändchen elektrisch miteinander verschaltet sind. Auf der Rückseite werden die Module mit einer witterungsfesten Kunststoffverbundsfolie, beispielsweise aus Polyvinylfluorid oder Polyester, oder einer weiteren Glasscheibe, abgeschlossen. Bei der Fertigung von PV-Modulen werden diese in der Regel bei etwa 150°C laminiert. Beim Laminieren bildet sich aus der bis dahin milchigen EVA-Folie eine klare, dreidimensional vernetzte und nicht mehr aufschmelzbare Kunststoffschicht, in der die PV-Zellen eingebettet sind und die fest mit der Glasscheibe und der Rückseitenfolie verbunden ist.

Mono- und mehrkristalline PV-Zellen werden aus sogenannten Wafern (einkristalline oder mehrkristalline Siliziumscheiben) hergestellt, wie sie in gleicher oder ähnlicher Form auch für die Halbleiterherstellung verwendet werden. Diese Siliziumzellen weisen großtechnisch einen Wirkungsgrad von bis zu 20% oder mehr und eine Leistungsdichte von 20 - 50 W/kg auf. Mehrere dieser Zellen werden in einem PV-Modul mittels Lötbändchen zu einzelnen Strängen (sogenannte Strings) in Serie geschaltet, bis die richtige Ausgangsspannung erreicht ist. Mehrere solcher Zellgruppen werden daraufhin entweder wieder seriell oder parallel geschaltet, wobei im ersten Fall die Spannungen und im zweiten Fall die Ausgangsströme addiert und zu den Modulanschlüssen geführt werden. Die dazu verwendeten Leitungen werden als Busbars bezeichnet. Für die Verstringung der Zellen muss jeweils die Vorderseite einer Zelle (z.B. Minuspol) mit der Rückseite der nächsten Zelle (Pluspol) verbunden werden, wozu häufig verzinnte Kupferbändchen eingesetzt werden. Diese PV-Zellen mit dieser Art der Anschlussanordnung werden auch als sogenannte H-Zellen bezeichnet. Zudem sind PV-Zellen mit sogenannter Rückseitenkontaktierung erhältlich. Bei der Rückseitenkontaktierung wird der Frontkontakt durch entsprechende Auslegung der Zelle auf die Rückseite geführt, so dass beide Kontakte (+/-) auf der gleichen Seite, d.h. der Rückseite, zugänglich sind. Ein solches PV-Modul mit Rückseitenkontakt ist beispielsweise in der EP 1 449 261 B1 beschrieben. Die Kontaktierung erfolgt nur noch von einer Seite mittels Bändchen oder vorzugsweise mittels flächiger Leiter, was die Handhabung vereinfacht und gleichzeitig die Abschattung durch die auf der Zelle liegenden Bändchen beseitigt.

Die Rückseite eines PV-Moduls muss eine Vielzahl von Anforderungen erfüllen. Zum Einen muss diese das Innenleben des Moduls vor Umwelteinflüssen, wie dem Eindringen von Feuchte oder UV-Strahlung, schützen. Zudem muss sie elektrisch isolierend sein und eine genügende mechanische Stabilität aufweisen. Weiterhin muss es möglich sein, die elektrischen Anschlussleitungen von der Anschlussdose außerhalb des PV-Moduls so durch die Rückseite des Moduls zu führen, dass keine Beeinträchtigungen der vorher genannten Schutzwirkungen auftreten.

Heute sind verschiedene Ausgestaltungen für Modulrückseiten bekannt. Typischerweise werden Kombinationen von witterungsfesten Kunststofffolien verwendet oder es wird Glas eingesetzt. Ein Aufbau eines solchen PV-Moduls ist beispielsweise in der Offenlegungsschrift US 2010/0139757 A1 beschrieben. Insbesondere die Verwendung von Glas ergibt einen sehr guten Schutz vor Umgebungseinflüssen hat aber den Nachteil, dass dies ein hohes Gewicht mit sich bringt und auch einen erhöhten Kostenfaktor darstellt.

**Die** WO 2010/099080 A2 **beschreibt beispielsweise ein System und ein Verfahren für eineverbesserte Struktur und Verkapselung von PV-Modulen. Das PV-Modul, umfasst ein Front-Schicht und eine photovoltaische Einheit, wobei die photovoltaische Einheit an der Frontschicht (Glas) befestigt ist und die photovoltaische Einheit aus mindestens einer PV-Zelle und einer Membran besteht. Die Membran und die Frontschicht dienen hierbei der Einbettung der photovoltaischen Einheit wobei die Membran zusätzlich den Vorteil bietet, dass bei Beschädigung der Frontschicht die zerbrochenen Teile zusammengehalten werden.**

**Aus der** US 2010/051085 A1 **ist zudem ein Foliensystem für Photovoltaik-Anwendungen mit Metallfolienrückseite bekannt, welche eine Metallfolie und eine Isolationsschicht, die auf die Metallfolie aufgebracht ist, umfasst Dieses Foliensystem hat die Aufgabe, Zellen elektrisch miteinander zu verbinden, und den Strom großflächig durch die Metallschicht zu sammeln und großflächig zur Nachbarzelle weiterzuleiten. Das beschriebene** Foliensystem gewährt aber keinen hinreichenden Schutz vor äußeren Einflüssen.

Die Aufgabe der vorliegenden Erfindung war es daher, eine PV-Modulrückseite zu entwickeln, welche die nötigen Schutzfunktionen vor Umwelteinflüssen erfüllt und zudem keine Öffnungen für Durchführungen der Modulanschlüsse benötigt. Für die Verwendung eines PV-Moduls ist ebenfalls von Bedeutung, wenn die Rückseite kein hohes Gewicht aufweist und kostengünstig zu realisieren ist.

Gelöst wird die Aufgabe durch das erfindungsgemäße Verbundsystem für Photovoltaik-**Modul**, welches eine Metallfolie und eine Isolationsschicht, die auf die Metallfolie aufgebracht ist, umfasst, wobei die Metallfolie als Rückwand des PV-Moduls dient, und die Metallfolie Kontaktinseln enthält, welche **von Freilegungen umgeben sind und** sowohl den Kontakt zur PV-Zellenverschaltung als auch die elektrische Verbindung des Moduls zum Bereich außerhalb des Moduls herstellen. **Die Kontaktinseln sind erfindungsgemäß die einzige Leiterstruktur, die in die Metallfolie eingebracht wird. Außerdem ist die Metallfolie elektrisch mit dem Erdpotential verbunden und die Isolationsschicht stellt die elektrische Isolation zwischen der elektrischen Verschaltung der PV-Zellen und der Rückwand des Moduls dar.**

I.d.R. sind pro String der nach aussen verbunden werden soll zwei Kontaktinseln (+ und - Pole) notwendig. Die Kontaktinseln in der Metallschicht sind nach Außen durch eine Anschlussdose abgedeckt, welche die weitere elektrische Verbindung des PV-Moduls zum Bereich außerhalb des Moduls darstellt. Unter Rückwand des PV-Moduls im Sinne der vorliegenden Erfindung ist dabei der rückseitige Abschluss des PV-Moduls zur Außenwelt zu verstehen.

Durch die vorhandenen Kontaktinseln auf der Metallfolie wird erreicht, dass die Rückseite des PV-Moduls nicht mechanisch geöffnet werden muss, um Anschlussleitungen von außen ins Innere des Moduls zu führen. Verbindungsdistanzen können zugleich kurz gehalten werden, wodurch der ohmsche Widerstand verringert wird. Das erfindungsgemäße Verbundsystem erlaubt so eine einfache und kostengünstige Produktion von Photovoltaikmodulen und eine Verbesserung der Effizienz und Zuverlässigkeit. Zudem ist dieses Verbundsystem durch entsprechende Platzierung der Kontaktinseln für alle PV-Waferzellen-Module anwendbar.

Die Metallfolie und die Isolationsschicht dienen als Rückwand (contacfoil-back) des erfindungsgemäßen Verbundsystems. Über dieser Schicht sind weitere Funktionsschichten in Form eines Foliensystems in dem PV-Modul vorhanden, welche hauptsächlich der Verschaltung der PV-Zellen dienen. Dieses Foliensystem besteht aus einer Metallschicht und einer Isolationsschicht (contacfoil-connect). Weiterhin sind eine aktive Schicht, ein Einbettmaterial und ein Frontglas vorhanden. Solch ein Foliensystem, welches sich über dem erfindungsgemäßen Verbundsystem (contacfoil-back) befindet, wird beispielsweise in der WO 2011/003969 A2 beschrieben.

Das vorliegende Verbundsystem hat den Vorteil, dass die Metallfolie als Modulabschluss und als Diffusionsbarriere dient, sie ist UV-beständig und sie kann elektrisch mit dem Erdpotential verbunden werden, was die Sicherheit bei einem Kurzschluss erhöht. Gleichzeitig erlaubt diese Rückwand über Kontaktinseln die Stromabfuhr aus dem Modul, ohne dass die Rückseite mechanisch geöffnet werden muss. Das Öffnen der Modulrückseite ist bei PV-Modulen aus dem Stand der Technik notwendig und birgt die Gefahr, dass Feuchte ins Modul eindringen kann. Die Kontaktinseln sind zudem die einzige "Leiterstruktur", die in die Metallschicht eingebracht werden muss. Hinter diesen Kontaktinseln ist die Isolationsschicht zu öffnen, so dass eine Verbindung zum Leiter von "contacfoil-connect" hergestellt werden kann. Zudem ist das Foliensystem leicht und kostengünstig.

Die Isolationsschicht wird haftend auf die Metallfolie aufgebracht und isoliert die Zelle bzw. die zur Verschaltung der Zellen benötigten Leiterstrukturen elektrisch von der Metallfolie. An den Kontaktierungsstellen ist die Isolationsschicht unterbrochen, damit elektrische Kontakte zwischen der Metallfolie innerhalb des Verbundsystems und der PV-Zellen hergestellt werden können. Dies kann durch mechanische Abtragung oder eine Abtragung mittels Laser geschehen. Die Isolationsschicht ist außerdem entweder selbst haftend oder mit einem Verbindungsmittel versehen. Dies erleichtert das Fixieren von Zellen auf dem Folienverbund.

Es ist weiterhin bevorzugt, dass die Isolationsschicht aus einem geeigneten Kunststoff besteht, der optisch im nahen IR-Bereich transparent ist und haftende Eigenschaften hat bzw. bei erhöhter Temperatur solche Eigenschaften entwickelt. Zudem sollte die Isolationsschicht aus einem Material bestehen, welches einen spezifischen Volumenwiderstand von >1e13Ohm*cm aufweist. Materialien, die diese und die anderen Anforderungen aufweisen sind vorzugsweise Copolymere, beispielsweise Ethylenvinylacetat (EVA), siliconbasierte Kunststoffe, beispielsweise Tectosil (Wacker) und/oder lonomere. Diese Materialien haben den Vorteil, dass gleichzeitig eine Haftung erreicht wird, so dass sich die einzelnen Komponenten während des Laminationsprozesses nicht verschieben. Außerdem können dank des hohen spezifischen Volumenwiderstands die Schichtdicken dünn gehalten werden (vorzugsweise 100µm), was Material einspart. Natürlich können auch andere Materialien mit tieferem spezifischen Volumenwiderstand eingesetzt werden, allerdings mit deutlich höheren Schichtdicken von vorzugsweise > 2mm.

In einer weiteren Ausgestaltungsform ist die Isolationsschicht mit einem Verbindungsmittel, vorzugsweise einem Kleber, versehen. Im Bereich der Kontaktinseln kann die Verbindung zwischen der Metallschicht und der Leiterstruktur, welche die Zellen verbindet mittels unterschiedlicher Verbindungstechniken hergestellt werden. In einer vorteilhaften Ausgestaltungsform des erfindungsgemäßen Verbundsystems wird dieses mit Hilfe eines elektrisch leitenden Klebers verbunden, der während des Laminationsprozesses ausgehärtet wird. In einer alternativen Ausgestaltung wird diese Verbindung mechanisch durch Verpressen während der Lamination oder durch Laserbearbeitung hergestellt. Alternativ ist es ebenfalls möglich, dass während der Lamination gleichzeitig elektrische Verbindungen durch Löten hergestellt werden, vorzugsweise mittels tiefschmelzendem Lot.

Es ist weiterhin Gegenstand des erfindungsgemäßen Verbundsystems, dass die Metallschicht aus Kupfer oder vorzugsweise aus Aluminium besteht.

In einer weiteren vorteilhaften Ausgestaltung weist die Metallfolie eine Dicke von mehr als 50 µm auf, vorzugsweise 100 µm bis 1000 µm. Da die Metallfolie als Rückseite des PV-Moduls dient, ist es notwendig dickere Materialstärken zu verwenden als bei Metallfolien eines PV-Moduls, bei dem die Metallfolie nicht zugleich als Rückseite ausgestaltet ist (contacfoil-connect).

In einer weiteren vorteilhaften Ausgestaltung weist die Isolationsfolie eine Dicke von mehr als 50 µm auf, vorzugsweise 100 µm bis 1000 µm auf.

Weiterhin ist es bevorzugt, dass die Metallfolie mit einer Beschichtung versehen ist, vorzugsweise aus reinem oder legiertem Kupfer oder Nickellegierungen , welche gut mittels Lot und/oder Leitkleber und/oder Bonding zu kontaktieren ist. Diese Beschichtung erfolgt bevorzugt im Bereich der Kontaktinseln und kann einseitig (Richtung contacfoil-connect) oder beidseitig sein, um die Kontaktierung des vorzugsweise verwendeten Aluminium zu erlauben bzw. zu verbessern.

Die Kontaktierungsöffnungen in der Isolationsschicht sind bevorzugt mit einem Kleber oder Lot gefüllt, um die Kontaktierung des vorzugsweise verwendeten Aluminiums der Metallfolie zu erlauben bzw. zu verbessern. Die Kontaktinseln sind von Freilegungen umgeben. Unterhalb einer Kontaktinsel ist eine Anschlussdose vorhanden, wodurch das PV-Modul zum Bereich außerhalb des Moduls verbunden ist. Die Anschlussdose ist dabei mit einer Vergussmasse ausgefüllt. Direkt unterhalb einer Kontaktinsel ist eine Anschlussleitung vorhanden, durch welche das PV-Modul über die Kontaktinsel mit der Anschlussdose verbunden ist.

Die Metallfolie übernimmt damit verschiedene Funktionen in dem PV-Modul. Neben der Funktion als Rückwand des PV-Moduls dient die Metallfolie als elektrische Verbindung des PV-Moduls. Die Kontaktinseln sind die einzige "Leiterstruktur", die in die Metallschicht eingebracht werden muss.

Weitere Vorteile ergeben sich aus einem Verfahren zur Herstellung eines Verbundsystems für Photovoltaik-Anwendung mit Metallfolienrückseite. Das Verfahren beinhaltet die folgenden Verfahrensschritte: Eine Metallfolie wird hergestellt und mit einer Beschichtung versehen, welche vorzugsweise aus reinem oder legiertem Kupfer oder Nickellegierungen besteht. Diese Beschichtung erfolgt bevorzugt im Bereich der späteren Kontaktinseln und kann einseitig (Richtung contacfoil-connect) oder beidseitig erfolgen. Diese Beschichtung soll mittels Lot und/oder Leitkleber und/oder Bonding die Kontaktierung des vorzugsweise verwendeten Aluminiums der Metallfolie erlauben bzw. verbessern.

Anschließend wird die Metallfolie mit einer Isolationsschicht durch eine haftende Verbindung zusammengefügt. Dazu ist die Isolationsschicht entweder selbst haftend oder es wird ein Verbindungsmittel, vorzugsweise ein Kleber, eingesetzt. Alternativ ist es möglich, die Isolationsschicht mittels direkter Extrusion auf die Metallschicht aufzubringen. Während oder nach dem Verbinden der Metallfolie und der Isolationsschicht wird die Metallfolie beispielsweise mittels eines Laserprozesses entweder direkt oder durch die transparente Isolationsschicht hindurch, lokal, selektiv um die Kontaktinsel herum, abgetragen. Dafür kommt vorzugsweise ein Laser mit einer Wellenlänge im nahen Infrarot, wie ein Faserlaser oder ein NdYag-Laser zur Anwendung. Die Kontaktinseln sind von Freilegungen umgeben. Insbesondere können in der Metallfolie Zonen abgetrennt werden, die auf der einen Seite mit der inneren Modulschaltung und auf der anderen Seite mit den äußeren Modulanschlüssen verbunden sind. Anschließend wird die Isolationsschicht ebenfalls an bestimmten Stellen selektiv entfernt. Diese Kontaktierungsöffnungen stellen einerseits die elektrische Verbindung zu den Kontaktinseln der Metallfolienrückwand sowie die elektrischen Kontakte zu der aktiven Schicht her. Dafür wird idealerweise ein IR-Laser, beispielsweise ein CO₂-Laser, angewendet. Die Geometrie der Freilegungen der Kontaktinseln ist so gewählt, dass das Foliensystem insgesamt intakt bleibt, also keine durchgehenden Öffnungen aufweist, aber auch so dass keine elektrische Verbindung zwischen dem Leiter der Kontaktinseln und dem weiteren Metall der Modulrückseite mehr besteht.

Bevorzugt wird das erfindungsgemäße Verfahren über einen "Roll-to-Roll" Prozess durchgeführt. Dazu wird die Isolationsschicht mittels Extrusion auf die Metallschicht aufgebracht. Dieser Verbund beider Schichten wird zunächst auf eine Rolle gewickelt und anschließend wieder abgewickelt. Mittels eines ersten Laserprozesse werden (in Transportrichtung) die Kontaktinseln in die Metallschicht eingeschnitten. In einem zweiten Laserprozess, beispielsweise mit einem CO₂-Laser, wird die transparente Isolationsschicht selektiv an den Kontaktöffnungen der Metallfolie geöffnet (Kontaktöffnungen). Anschließend wird das Foliensystem in formatübliche Größen geschnitten und für den Zusammenbau der PV-Module verwendet.

Es ist dabei bevorzugt, dass die Isolationsschicht einen spezifischen Volumenwiderstand von >1e13Ohm*cm aufweist. Bevorzugte Materialien für die Isolationsschicht sind Copolymere, beispielsweise Ethylenvinylacetat (EVA), siliconbasierte Kunststoffe, beispielsweise Tectosil (Wacker) und/oder thermoplastische Kunststoffe, beispielsweise lonomere. Diese Materialien haben den Vorteil, dass gleichzeitig eine Haftung erreicht wird, so dass sich die einzelnen Komponenten während des Laminationsprozesses nicht verschieben. Die Isolationsschicht ist dabei vorzugsweise im nahen IR-Bereich optisch transparent, um die Laserbearbeitung der Metallschicht durch die Isolationsschicht zu erlauben. Bei einem weiteren geeigneten Kunststoff, der haftende Eigenschaften aufweist und für die Isolationsschicht verwendet wird, handelt es sich vorzugsweise um Polyvinylbutyral (PVB).

Zur Herstellung einer elektrischen Verbindung zwischen dem Verbundsystem und der Leiterschicht, welche die Zellen verbindet, wird vorzugsweise ein thermisch aushärtender, elektrisch leitender Kleber auf den Kontaktierungsöffnungen oder ein tiefschmelzendes Lot verwendet. Alternativ kann die Verbindung mittels eines Laserlötprozesses oder durch Bonding erfolgen. Eine weitere Alternative der elektrischen Verbindung ist das mechanische Verpressen des Verbundsystems mit den Kontaktierungsöffnungen.

Das somit hergestellte Verbundsystem kann in einem Prozess, beispielsweise Lamination oder Verpressen mit den verschalteten PV-Zellen verbunden werden.

In einer alternativen Ausgestaltungsform des erfindungsgemäßen Verfahrens werden während des Laminationsvorgangs in einem Verfahrensschritt zusätzlich elektrische Verbindungen zwischen dem Verbundsystem und den PV-Zellen hergestellt, vorzugsweise mittels Löten besonders bevorzugt unter Verwendung von tiefschmelzendem Lot; das Modul nach hinten verschlossen; ein Deckglas aufgebracht und/oder die Einbettung der PV-Zellen bewerkstelligt.

Gegenstand der Erfindung ist zudem die Verwendung eines Verbundsystems als Rückseite und Stromabführung von Waferzellen-Modulen. Dazu wird eine Isolationsschicht auf eine Metallfolie aufgebracht. Die Zellenverschaltung haftet auf der Isolationsschicht und wird so fixiert. Über Kontaktinseln auf der Metallfolie und Kontaktöffnungen in der Isolationsschicht ist die Metallschicht mit der Zellenverschaltung verbunden. Die Metallfolie bildet somit den rückseitigen Modulabschluss als Schutz vor Umwelteinflüssen, wobei die Kontaktinseln in der Metallschicht den Anschluss des Moduls nach Außen erlauben und durch eine Anschlussbox abgedeckt sind.

Die vorliegende Erfindung wird anhand folgender Figuren näher erläutert. Es zeigen:
Fig. 1 einen schematischen Querschnitt durch das erfindungsgemäße Verbundsystem für Photovoltaik-Anwendungen mit Metallfolienrückseite,
Fig. 2 eine schematische Übersicht der Metallfolienrückseite und der Isolationsschicht des erfindungsgemäßen PV-Moduls.

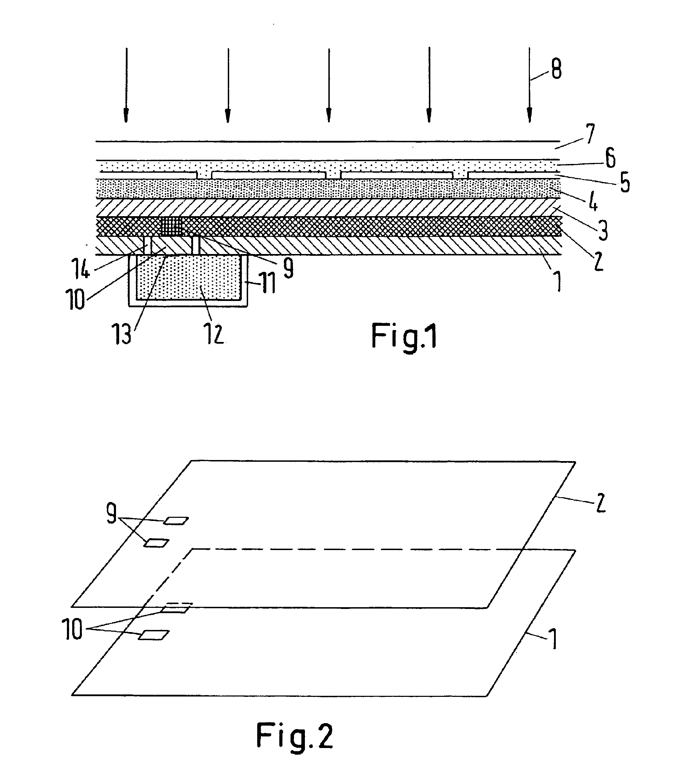

Fig. 1 zeigt einen schematischen Querschnitt durch das erfindungsgemäße Verbundsystem für Photovoltaik-Anwendungen bei denen so genannte Rückseitenkontaktierte Zellen zur Anwendung gelangen. Die Stärken der einzelnen Schichten sind dabei ebenfalls lediglich schematisch dargestellt und stehen nicht im Verhältnis zueinander. Die Metallfolie (1) stellt die Verbindung zum Verschluss des Moduls gegen Umwelteinflüsse her. Auf dieser Metallfolie ist eine Isolationsschicht (2) aufgebracht. Diese beiden Schichten dienen als Rückwand (contacfoil-back) des erfindungsgemäßen Verbundsystems. Über dem "contacfoil-back" befinden sich weitere Schichten. Dieses besteht aus einer Metallschicht (3), welche als Verbindung zu den PV-Zellen (5) dient und einer Isolationsschicht (4), welche die Isolation zu den Zellen (5) darstellt, das sogenannte "contacfoil-connect" Foliensystem. Über der aktiven Schicht (5), welche aus den PV-Zellen besteht, ist ein Einbettmaterial (6) und ein Frontglas (7) vorhanden, durch welche das Licht (8) auf die aktive Schicht fällt.

In dieser Abbildung sind exemplarisch eine Kontaktierungsöffnung (9) und eine Kontaktinsel (10) dargestellt. Die Kontaktierungsöffnungen (9) sind bevorzugt mit einem Kleber oder Lot gefüllt, um die Kontaktierung des vorzugsweise verwendeten Aluminiums der Metallfolie zu erlauben bzw. zu verbessern. Die Kontaktinseln (10) sind von Freilegungen (14) umgeben. Unterhalb einer Kontaktinsel (10) ist eine Anschlussdose vorhanden, wodurch das PV-Modul zum Bereich außerhalb des Moduls verbunden ist. Die Anschlussdose (11) ist dabei mit einer Vergussmasse (12) ausgefüllt. Direkt unterhalb einer Kontaktinsel (10) ist eine Anschlussleitung (13) vorhanden, durch welche das PV-Modul über die Kontaktinsel (10) mit der Anschlussdose (11) verbunden ist.

Fig. 2 zeigt eine schematische Übersicht der Schichten der Metallfolienrückseite und der Isolationsschicht des erfindungsgemäßen PV-Moduls. Die Metallfolie (1) dient als Rückwand für das PV-Modul. Auf dieser Metallfolie (1) ist eine Isolationsschicht (2) aufgebracht. Die Isolationsschicht (2) fixiert die Metallfolie mechanisch mit den übrigen Folienschichten, die für die Verschaltung der PV-Zellen notwendig sind. Zudem dient die Isolationsschicht (2) zur Isolation der elektrisch leitenden Schicht (3) und der Metallfolie (1). In der Isolationsschicht (2) sind Kontaktierungsöffnungen (9) vorhanden, welche die elektrische Verbindung zu den Kontaktinseln (10) der Metallfolie (1) darstellen. Über einen Laserprozess wird die Metallschicht selektiv um die Kontaktinsel (10) herum abgetragen. Dafür kommt vorzugsweise ein Laser mit einer Wellenlänge im nahen IR zur Anwendung. Auf die gleiche Weise wird im Bereich der Kontaktierungsöffnungen (9) die Isolationsschicht selektiv entfernt, so dass die elektrische Verbindung zur Modulschaltung möglich wird. Dafür wird idealerweise ein IR-Laser angewendet. Die Geometrie der Freilegungen der Kontaktinseln (10) und Kontaktierungsöffnungen (9) ist so gewählt, dass das Foliensystem insgesamt intakt bleibt, also keine durchgehenden Öffnungen aufweist. Diese Kontaktinseln (10) dienen sowohl zur Kontaktierung der Metallfolie (3), welche die Zellenverbindung herstellt nach oben (z.B. zu contacfoil-connect) über die Kontaktierungsöffnungen (9) der Isolationsschicht (2), als auch der Anschlüsse des PV-Moduls zum Außenbereich.

### Bezugszeichenliste

- 1.: Metallfolie (Rückseite)
- 2.: Isolationsschicht (Rückseite)
- 3.: Metallfolie (Zellenverbindung)
- 4.: Isolationsschicht (zu den Zellen)
- 5.: aktive Schicht (Zellen)
- 6.: Einbettmaterial
- 7.: Frontschicht
- 8.: Lichteinfall
- 9.: Kontaktierungsöffnungen
- 10.: Kontaktinseln
- 11.: Anschlussdose
- 12.: Vergussmasse
- 13.: Anschlussleitung
- 14.: Freilegung

## Patentansprüche

1. Verbundsystem für Photovoltaik-**Modul** mit Metallfolienrückseite, umfassend:
- eine Metallfolie (1), und
- eine Isolationsschicht (2), welche auf die Metallfolie **(1)** aufgebracht ist, **dadurch gekennzeichnet, dass** die Metallfolie **(1)** als Rückwand des PV-Moduls dient, wobei die Metallfolie Kontaktinseln **(10)** enthält, welche **von Freilegungen (14) umgeben sind und** sowohl den Kontakt zur PV-Zellenverschaltung als auch die elektrische Verbindung des Moduls zum Bereich außerhalb des Moduls herstellen,
wobei die Kontaktinseln **(10)** die einzige Leiterstruktur sind, die in die Metallfolie **(1)** eingebracht wird und die Metallfolie **(1)** elektrisch mit dem Erdpotential verbunden ist **und die Isolationsschicht (2) die elektrische Isolation zwischen der elektrischen Verschaltung der PV-Zellen und Rückwand des Moduls darstellt**.

2. Verbundsystem nach **Anspruch 1**, **dadurch gekennzeichnet, dass** die Isolationsschicht (2)
- aus Copolymeren, vorzugsweise EVA, und/oder siliconbasierten Kunststoffen und/oder lonomeren besteht, und/oder
- einen spezifischen Volumenwiderstand von >1e13Ohm*cm aufweist, und/oder
- eine Dicke von mehr als 50µm, vorzugsweise 100µm bis 1000µm aufweist; und/oder
- aus PVB besteht
- mit einem Verbindungsmittel versehen ist, wobei es sich bei dem Verbindungsmittel um einen Kleber handelt und/oder die Isolationsschicht **(2)** haftend ausgestattet ist.

3. Verbundsystem nach **den Ansprüchen 1 oder 2**,
**dadurch gekennzeichnet, dass** die Metallfolie (1)
- aus Kupfer oder vorzugsweise aus Aluminium besteht; und/oder
- eine Dicke von mehr als 50 µm, vorzugsweise 100 µm bis 1000 µm aufweist; und/oder
- mit einer Beschichtung versehen ist, vorzugsweise aus reinem oder legiertem Kupfer oder Nickellegierungen , welche gut mittels Lot und/oder Leitkleber und/oder Bonding zu kontaktierenden ist.

4. Verfahren zur Herstellung eines Verbundsystems nach einem der Ansprüche 1 bis **3** für PV-Module umfassend folgende Verfahrensschritte:
- Herstellen einer Metallfolie **(1)**,
- Verbinden einer Metallfolie **(1)** mit einer Isolationsschicht**(2)** durch eine haftende Verbindung,
- Öffnen der Isolationsschicht **(2)** für Kontaktierung **(9)**, so dass die Metallfolie **(1)** über die Kontaktinseln**(10)** sowohl den Kontakt zur PV-Zellenverschaltung als auch die elektrische Verbindung des Moduls zum Bereich außerhalb des Moduls darstellt.

5. Verfahren zur Herstellung eines Verbundsystems nach einem der Ansprüche 1 bis **3** für PV-Module umfassend folgende Verfahrensschritte:
- Herstellen einer Metallfolie **(1)**,
- direkte Extrusion einer Isolationsschicht **(2)** auf die Metallschicht **(1)**, so dass die Isolationsschicht **(2)** auf der Metallfolie **(1)** haftet,
- Öffnen der Isolationsschicht **(2)** für Kontaktierung **(9)**, so dass die Metallfolie **(1)** über die Kontaktinseln **(10)** sowohl den Kontakt zur PV-Zellenverschaltung als auch die elektrische Verbindung des Moduls zum Bereich außerhalb des Moduls darstellt.

6. Verfahren nach Anspruch **4 oder 5**, **dadurch gekennzeichnet, dass**
- während oder nach dem Verbinden der Metallfolie (1) und der Isolationsschicht (2) eine Leiterbahnstruktur in Form von Kontaktinseln (10), vorzugsweise mittels eines Laserverfahrens in die Metallfolie (1) geschnitten wird; und/oder
- die Metallfolie (1) in Transportrichtung während des Verbindens mit der Isolationsschicht (2) beschnitten wird, vorzugsweise mittels eines Laserverfahrens; und/oder
- zur Herstellung einer elektrischen Verbindung zwischen dem Verbundsystem und der Leiterschicht, welche die Zellen verbindet, ein thermisch aushärtender, elektrisch leitender Kleber auf den Kontaktierungsöffnungen **(9)** verwendet wird, oder ein Laserlötprozess oder ein tiefschmelzendes Lot verwendet; und/oder
- das Verbundsystem mit dem zur Kontaktierung der Zellen verwendeten Verbundsystem durch Lamination oder Verpressen verbunden wird, so dass eine elektrische Verbindung der verschalteten Zellen **(5)** zu den Kontaktinseln **(10)** entsteht; und/oder
- die Isolationsschicht**(2)** aus Copolymeren, vorzugsweise EVA, und/oder siliconbasierten Kunststoffen und/oder lonomeren besteht, und/oder
- eine Dicke von mehr als 50µm, vorzugsweise 100µm bis 1000µm aufweist; und/oder
- aus PVB besteht
- die Isolationsschicht einen spezifischen Volumenwiderstand von >1e13Ohm*cm aufweist; und/oder
- zur Verbesserung der Kontaktierung die Metallfolie (1) vor dem Verbinden mit der Isolationsschicht (2) im Bereich der Kontaktinseln **(10)** beschichtet wird, vorzugsweise mit Kupfer im Bereich der Kontaktinseln **(10)** beschichtet ist, vorzugsweise mit reinem oder legiertem Kupfer oder Nickellegierungen..

7. Verfahren nach den Ansprüchen **4 bis 6**, **dadurch gekennzeichnet, dass** während des Laminationsvorgangs in einem Verfahrensschritt zusätzlich
- elektrische Verbindungen zwischen den Kontaktinseln **(10)** des Verbundsystems und den verschalteten PV-Zellen hergestellt werden, vorzugsweise mittels Löten besonders bevorzugt unter Verwendung von tiefschmelzendem Lot;
- ein Frontglas **(7)** aufgebracht wird und/oder
- die Einbettung und Verschaltung der PV-Zellen bewerkstelligt wird.

8. Verwendung eines Verbundsystems nach einem der Ansprüche 1 bis **3** als Rückseite und Stromabführung von Waferzellen-Modulen, **dadurch gekennzeichnet, dass**
- die Kontaktinseln **(10)** in der Metallschicht **(1)** mit der Zellenverschaltung verbunden werden; und/oder
- die Zellenverschaltung auf der Isolationsschicht **(2)** haftet und so fixiert wird; und/oder
- die Metallfolie (1) den rückseitigen Modulabschluss als Schutz vor Umwelteinflüssen bildet, wobei die Kontaktinseln **(10)** in der Metallschicht **(1)** den Anschluss des Moduls nach Außen erlauben und durch eine Anschlussbox **(11)** abgedeckt sind.

## Claims

1. Compound system for a photovoltaic module with a metal film reverse, comprising:
- a metal film (1), and
- an insulation layer (2), which is applied to the metal film (1),
**characterized in that**
the metal film (1) serves as a rear wall of the PV module, wherein the metal film contains contact pads (10), which are surrounded by exposed areas (14) and which both produce the contact with the PV-cell interconnection wiring and also make the electrical connection of the module to the region outside the module, wherein the contact pads (10) are the only conductor structure which is introduced into the metal film (1) and the metal film (1) is electrically connected to the ground potential and the insulation layer (2) constitutes the electrical insulation between the electrical interconnection wiring of the PV cells and the rear wall of the module.

2. Compound system according to Claim 1, **characterized in that** the insulation layer (2)
- consists of copolymers, preferably EVA, and/or silicone-based plastics and/or ionomers, and/or
- has a specific volume resistivity of >1e13Ohm * cm, and/or
- has a thickness of greater than 50µm, preferably 100µm to 1000µm; and/or
- consists of PVB
- is provided with a connecting means, said connecting means being an adhesive and/or the insulation layer (2) being self-adhesive.

3. Compound system according to Claims 1 or 2, **characterized in that** the metal film (1)
- consists of copper or preferably aluminium; and/or
- has a thickness of greater than 50µm, preferably 100µm to 1000µm; and/or
- is provided with a coating, preferably made of pure or alloyed copper or of nickel alloys, which can be readily contacted by means of solder and/or conductive adhesives and/or bonding.

4. Method for producing a compound system according to any one of Claims 1 to 3 for PV modules, comprising the following method steps:
- producing a metal film (1),
- connecting a metal film (1) to an insulation layer (2) by means of an adhesive connection,
- opening the insulation layer (2) for contacting (9), so that the metal film (1), via the contact pads (10), provides both the contact with the interconnection wiring and also the electrical connection of the module to the region outside the module.

5. Method for producing a compound system according to any one of Claims 1 to 3 for PV modules, comprising the following method steps:
- producing a metal film (1),
- direct extrusion of an insulation layer (2) onto the metal layer (1) so that the insulation layer (2) adheres to the metal film (1),
- opening the insulation layer (2) for contacting (9), so that the metal film (1), via the contact pads (10), provides both the contact with the interconnection wiring and also the electrical connection of the module to the region outside the module.

6. Method according to Claim 4 or 5, **characterised in that**
- during or after the connection of the metal film (1) and the insulation layer (2), a conductor track structure in the form of contact pads (10) is cut into the metal film (1), preferably by means of a laser method; and/or
- the metal film (1) is cut away in the transport direction during the connection to the insulation layer (2), preferably by means of a laser method; and/or
- to produce an electrical connection between the compound system and the conductor layer which connects the cells, a thermally curing, electrically conductive adhesive is used on the contacting openings (9), or a laser soldering process or a low-fusing solder is used; and/or
- the compound system is connected to the compound system that is used for contacting the cells by means of lamination or pressing, so that an electrical connection of the interconnected cells (5) to the contact pads (10) is obtained; and/or
- the insulation layer (2) consists of copolymers, preferably EVA, and/or silicone-based plastics and/or ionomers, and/or
- has a thickness of greater than 50µm, preferably from 100µm to 1000µm; and/or
- consists of PVB
- the insulation layer has a specific volume resistivity of >1e13Ohm * cm; and/or
- to improve the contacting, before connection to the insulation layer (2) the metal film (1) is coated in the region of the contact pads (10), is preferably coated with copper in the region of the contact pads (10), preferably with pure or alloyed copper or nickel alloys.

7. Method according to Claims 4 to 6, **characterized in that** additionally, in one process step during the lamination process
- electrical connections are produced between the contact pads (10) of the compound system and the interconnected PV cells, preferably by means of soldering, particularly preferably using low-fusing solder;
- a frontal glass (7) is applied and/or
- the embedding and interconnection of the PV-cells is carried out.

8. Use of a compound system according to any one of Claims 1 to 3 as a reverse and a current output terminal of wafer cell modules, **characterized in that**
- the contact pads (10) in the metal layer (1) are connected to the cell interconnection wiring; and/or
- the cell interconnection wiring adheres to the insulation layer (2) and is thus fixed in place; and/or
- the metal film (1) forms the closure of the module on the reverse side as protection against environmental influences, wherein the contact pads (10) in the metal layer (1) allow the connection of the module externally and are covered by a junction box (11).

## Revendications

1. Système composite pour module photovoltaïque avec face arrière en feuille métallique, comprenant :
- une feuille métallique (1), et
- une couche d'isolation (2), laquelle est appliquée sur la feuille métallique (1),
**caractérisé en ce que** la feuille métallique (1) sert de paroi arrière du module PV, la feuille métallique comprenant des plots de contact (10), lesquels sont entourés de dégagements (14) et établissent le contact avec l'interconnexion de cellules PV tout comme également la connexion électrique du module avec la zone à l'extérieur du module, les plots de contact (10) étant l'unique structure conductrice, laquelle est intégrée dans la feuille métallique (1), et la feuille métallique (1) étant connectée électriquement au potentiel de terre et la couche d'isolation (2) représentant l'isolation électrique entre l'interconnexion électrique des cellules PV et la paroi arrière du module.

2. Système composite selon la revendication 1, **caractérisé en ce que** la couche d'isolation (2)
- se compose de copolymères, de préférence d'EVA, et/ou de matières synthétiques à base de silicone et/ou d'ionomères, et/ou
- présente une résistivité volumique de >1e13ohms*cm, et/ou
- une épaisseur de plus de 50µm, de préférence de 100µm à 1000µm ; et/ou
- se compose de PVB
- est munie d'un agent de liaison, l'agent de liaison étant un adhésif et/ou la couche d'isolation (2) étant équipée de manière à adhérer.

3. Système composite selon les revendications 1 ou 2, **caractérisé en ce que** la feuille métallique (1)
- se compose de cuivre ou de préférence d'aluminium ; et/ou
- présente une épaisseur de plus de 50µm, de préférence de 100 µm à 1000 µm ; et/ou
- est munie d'un revêtement, de préférence en cuivre pur ou allié ou en alliages de nickel, lequel est facilement mis en contact à l'aide d'un métal d'apport et/ou d'un adhésif conducteur et/ou d'un bonding.

4. Procédé pour la fabrication d'un système composite selon l'une des revendications 1 à 3 pour modules PV comprenant les étapes suivantes du procédé :
- fabriquer une feuille métallique (1),
- relier une feuille métallique (1) à une couche d'isolation (2) grâce à une liaison adhésive,
- ouvrir la couche d'isolation (2) pour l'établissement d'un contact (9), de sorte que la feuille métallique (1) constitue, par l'intermédiaire des plots de contact (10), le contact avec l'interconnexion de cellules PV tout comme également la connexion électrique entre le module et la zone à l'extérieur du module.

5. Procédé pour la fabrication d'un système composite selon l'une des revendications 1 à 3 pour modules PV comprenant les étapes suivantes du procédé :
- fabrication d'une feuille métallique (1),
- extrusion directe d'une couche d'isolation (2) sur la couche métallique (1) de manière à ce que la couche d'isolation (2) adhère sur la couche métallique (1),
- ouverture de la couche d'isolation (2) pour l'établissement d'un contact (9), de sorte que la feuille métallique (1) constitue, par l'intermédiaire des plots de contact (10), le contact avec l'interconnexion de cellules PV tout comme également la connexion électrique entre le module et la zone à l'extérieur du module.

6. Procédé selon la revendication 4 ou 5, **caractérisé en ce que**,
- pendant que la feuille métallique (1) et la couche d'isolation (2) sont reliées ou après cela, une structure de piste conductrice sous la forme de plots de contact (10) est de préférence découpée à l'aide d'un procédé laser dans la feuille métallique (1) ; et/ou
- **en ce que** la feuille métallique (1) est coupée en direction de transport pendant la liaison avec la couche d'isolation (2), de préférence à l'aide d'un procédé laser ; et/ou
- **en ce que**, pour l'établissement d'une connexion électrique entre le système composite et la couche conductrice, laquelle relie les cellules, on utilise un adhésif électro-conducteur à durcissement thermique sur les ouvertures d'établissement d'un contact (9), ou bien un processus de soudage au laser ou un métal d'apport à bas point de fusion ; et/ou
- **en ce que** le système composite est relié par feuilletage ou pressage au système composite utilisé pour l'établissement d'un contact des cellules, de sorte qu'une connexion électrique est établie entre les cellules interconnectées (5) et les plots de contact (10) ; et/ou
- **en ce que** la couche d'isolation (2) se compose de copolymères, de préférence d'EVA, et/ou de matières synthétiques à base de silicone et/ou d'ionomères, et/ou
- présente une épaisseur de plus de 50µm, de préférence de 100µm à 1000µm ; et/ou
- se compose de PVB,
- la couche d'isolation présentant une résistivité volumique spécifique de > 1 e 13ohms*cm ; et/ou
- **en ce que**, pour l'amélioration de l'établissement d'un contact, la feuille métallique (1), avant d'être reliée à la couche d'isolation (2), est revêtue dans la zone des plots de contact (10), est de préférence revêtue avec du cuivre dans la zone des plots de contact (10), de préférence avec du cuivre pur ou allié ou des alliages de nickel.

7. Procédé selon les revendications 4 à 6, **caractérisé en ce que**, pendant le processus de feuilletage, dans une étape du procédé, de manière additionnelle,
- des connexions électriques entre les plots de contact (10) du système composite et les cellules PV interconnectées sont établies, de préférence grâce à un soudage, de manière particulièrement préférée en utilisant un métal d'apport à bas point de fusion ;
- un verre frontal (7) étant appliqué et/ou
- l'encapsulation et l'interconnexion des cellules PV étant réalisée.

8. Utilisation d'un système composite selon l'une des revendications 1 à 3 en tant que face arrière et évacuation de courant de modules à cellules de plaquette, **caractérisée en ce que**
- les plots de contact (10) dans la couche métallique (1) sont reliés à l'interconnexion de cellules ; et/ou
- **en ce que** l'interconnexion de cellules adhère sur la couche d'isolation (2) et est fixée ainsi; et/ou
- **en ce que** la feuille métallique (1) forme la terminaison de module du côté arrière en tant que protection contre des influences de l'environnement, les plots de contact (10) dans la couche métallique (1) permettant le raccordement du module vers l'extérieur et étant couverts par une boîte de connexion (11).
